# EUROPEAN PATENT SPECIFICATION

(11) **EP 1 469 037 B1**
(45) Date of publication and mention of the grant of the patent: **06.08.2008**
(21) Application number: 03700559.2
(22) Date of filing: 15.01.2003
(51) Int. Cl.: C08L 79/08, C08G 73/10, G03F 7/037, G03F 7/039

(54) **SOLVENT-SOLUBLE BLOCK COPOLYIMIDE COMPOSITION AND PROCESS FOR PRODUCING THE SAME**
LÖSUNGSMITTELLÖSLICHE BLOCK-COPOLYIMIDZUSAMMENSETZUNG UND HERSTELLUNGSVERFAHREN DAFÜR
COMPOSITION DE COPOLYIMIDE SEQUENCE SOLUBLE DANS LE SOLVANT ET PROCEDE DE PREPARATION ASSOCIE

(30) Priority: 15.01.2002 JP 2002005413; 15.01.2002 JP 2002005414
(43) Date of publication of application: 20.10.2004
(73) Proprietor: PI R & D Co., Ltd., Yokohama-shi, Kanagawa 236-0002 (JP)
(72) Inventor: JIN, Xingzhou, Yokohama-Shi, Kanagawa 234-0054 (JP); ISHII, Hiroyuki, Yokohama-Shi, Kanagawa 235-0033 (JP); MIYAMURA, Masataka, Kamakura-Shi, Kanagawa 248-0025 (JP); ITATANI, Hiroshi, Yokohama-Shi, Kanagawa 236-0005 (JP); HORI, Shinichiro, Yokohama-Shi, Kanagawa 235-0033 (JP); TANIGUCHI, Akihito, Kawasaki-Shi, Kanagawa 216-0002 (JP)
(74) Representative: Vossius & Partner
(86) International application number: PCT/JP2003/000252
(87) International publication number: WO 2003/060010

(56) References cited:
- EP-A1- 0 957 126
- WO-A1-00/41884
- JP-A- 4 108 880
- JP-A- 9 040 777
- JP-A- 11 202 488

## Description

The present invention relates to solvent-soluble polyimide composition. Having superior heat resistance, electrical insulation, mechanical properties and chemical resistance, polyimides now find wide applications in the form of electrical parts, electronic parts, semiconductor parts, communications equipments and their circuit parts, and peripheral equipments.

Polyimide resins, because of being less soluble in organic solvents, must be converted in polar solvents to polyamide acids, and then heated and dehydrated into films.

Recently discovered solvent-soluble polyimides have been used in coating applications and in the form of liquid crystal orientation films and insulating films for flexible substrates.

JP 11202488 discloses a positive photosensitive polyimide composition soluble in a solvent. JP 09040777 discloses a polyimide/siloxane block copolymer with excellent solvent solubility.

As solvents for dissolving polyimides therein, polar solvents such as N-methylpyrrolidone, N,N-dimethylformamide, N,N-dimethylacetylamide and dimethylsulfoxide are used.

Problems with polyimide varnishes and polyimide inks with which non-aqueous solvents are used are that when used in an environment having a relative humidity of 50% or higher, the surfaces of the resulting films or moldings become white.

Polyimide films, moldings, etc., once whitened, offer problems that even upon heated or dried, not only are films having toughness inherent in polyimides obtained, but also their own electrical or other properties are never obtained.

This whitening phenomenon, for the most part, would be due to the fact that polar solvents used for dissolution of polyimides, for instance, N-methylpyrrolidone, N,N-dimethylformamide and dimethylsulfoxide, absorb atmospheric moisture due to their high moisture absorption properties.

When polyimide resins dissolved in such solvents are used at coating or other steps, it is required to blow dry air or nitrogen gas into a coating system or provide it with a cover for preventing entrance of moisture from outside.

When polyimides are used with precision equipments such as those made of electronic materials, it is necessary to remove foreign or impure matters derived from them by means of precision filtration systems. In this case, too, it is required to replace atmospheres in the filtration systems or receivers such as bins by dried air or nitrogen gas or provide them with coverings for preventing entrance of moisture from outside.

When it comes to a process of making ink using polyimide resins, it is likewise necessary to blow dried air or nitrogen gas in a step of mixing it with fillers by roll or mill means, or provide the whole of an associated system with a cover for preventing entrance of moisture from outside.

To meet demands for electronic equipments having higher densities and higher degrees of integration, photosensitive polyimides that enable precise patterns to be formed by exposure are now used.

So far, a negative type of photosensitive polyimide has been used. In this case, development of an exposed portion is carried out using an organic solvent after that portion is converted by a crosslinking reaction to a three-dimensional, insoluble gel. However, a crosslinking type of photosensitive material is unfavorable for high-precision micro-processing because an exposed portion swells upon development by an organic solvent.

In some cases, a film whitened under the influence of moisture at a coating step may become transparent after prebaking. However, even such a transparent film becomes difficult to handle because of denaturing of the photooxygenation agent such as naphthoquinonediazides by moisture absorption. Problems with whitened polyimide films are that not only are any films having toughness inherent in polyimides obtainable, but also their own electrical properties, etc. are not obtainable.

A primary object of the present invention is, therefore, to provide a solvent-soluble block copolymerization polyimide composition that is substantially free from whitening phenomena ascribable to atmospheric air or the like. Another object of the invention is to provide a positive type photosensitive polyimide that has high resolution and reliability without being swollen by an aqueous alkali solution used as a developing solution.

The present invention provides a block copolymerization polyimide composition, wherein a block copolymerization type polyimide obtained from a tetracarboxylic dianhydride and a diamine is dissolved in at least one solvent selected from a ketone, an ether and an ester.

In the block copolymerization polyimide composition of the invention, the block copolymerization polyimide has been obtained by heating the tetracarboxylic dianhydride and diamine in at least one solvent selected from a ketone, an ether and an ester and in the presence of a catalyst resulting from a l'actone and a base.

In the block copolymerization polyimide composition of the invention, the tetracarboxylic dianhydride is at least one selected from the group consisting of 3, 3', 4, 4'-biphenyltetracarboxylic dianhydride (BPDA), 3, 3', 4, 4'-benzophenonetetracarboxylic dianhydride (BTDA), 3, 3', 4, 4'-biphenyl ether tetracarboxylic dianhydride (OPDA), 3, 3', 4, 4'-diphenylsulfonetetracarboxylic dianhydirde (DSDA), bicyclo(2,2,2)-oct-7-ene-2,3,5,6-tetracarboxylic dianhydride (BCD), 1,2,4,5-cyclohexanetetracarboxylic dianhydride (H-PMDA), pyromellitic dianhydride (PMDA), 2,2-bis (3,4-dicarboxyphenyl)hexafluoropropane dianhydride (6FDA), and 5-(2,5-dioxotetrahydrofuryl)-3-methyl-3-cyclohexne-1,2-dicarboxylic anhydride (CP).

In the block copolymerization polyimide composition of the invention, the diamine is at least one selected from the group consisting of siliconediamine, bis (3-aminopropyl) ether ethane, 3,3'-diamino-4,4'-dihydroxydiphenylsulfone (SO2-HOAB), 4,4'-diamino-3,3'-dihydroxybiphenyl (HOAB), 2,2-bis(3-amino-4-hydroxyphenyl hexafluoropropane (HOCF3AB), siloxanediamine, bis (3-aminopropyl) ether ethane, N,N-bis (3-aminopropyl) ether, 1,4-bis (3-aminopropyl) piperazine, isophoronediamine, 1,3'-bis(aminomethyl)cyclohexane, 3,3'-dimethyl-4,4'-diaminodicylohexylmethane, 4,4'-methylenebis (cyclohexylamine), 4,4'-diaminodiphenyl ether (p-DADE), 3,4'-diaminodiphenyl ether (m-DADE), 3,3-diaminodiphenyl ether, 4,4'-diamino-diphenylsulfone (p-DDS), 3,4'-diamino-diphenylsulfone, 3,3'-diamino-diphenylsulfone, 2,4'-diaminodiphenyl ether, 1,3-bis(4-aminophenoxy) benzene (m-TPE), 1,3-bis(3-aminophenoxy)benzene (APB), 2,2-bis[4-(4-aminophenoxy)phenyl]propane (BAPP), 2,2-bis[4-(4-aminophenoxy)phenyl]hexafluoropropane (HF-BAPP), bis[4-(4-aminophenoxy)phenyl]sulfone (p-BAPS), bis[4-(3-aminophenoxy)phenyl]sulfone (m-BAPS), 4,4'-bis(4-aminophenoxy) biphenyl (BAPB), 1,4-bis(4-aminophenoxy) benzene (p-TPE), 4,4'-diaminodiphenylsulfide (ASD), 3,4'-diaminodiphenylsulfide, 3,3'-diaminodiphenylsulfide, 3,3'-diamino-4, 4'-dihydorxydipheylsulfone, 2,4-diaminotoluene (DAT), 2,5-diaminotoluene, 3,5-diaminobenzoic acid (DABz), 2,6-diaminopyridine (DAPy), 4,4'-diamino-3,3'-dimethoxybiphenyl (CH3OAB), 4,4'-diamino-3,3'-dimethylbiphenyl (CH3AB), and 9,9'-bis(4-aminophenyl)fluorene (FDA).

In the block copolymerization polyimide composition of the invention, the ketone is at least one selected from the group consisting of methyl ethyl ketone, methyl propyl ketone, methyl isopropyl ketone, methyl butyl ketone, methyl isobutyl ketone, methyl n-hexyl ketone, diethyl ketone, diisopropyl ketone, diisobutyl ketone, cyclopentanone, cylcohexanone, methylcyclohexanone, acetylacetone, diacetone alcohol, and cyclohexen-1-one.

In the block copolymerization polyimide composition of the invention, the ether is at least one selected from the group consisting of dipropyl ether, diisopropyl ether, dibutyl ether, tetrahydrofuran, tetrahydropyran, ethyl isoamyl ether, ethyl-t-butyl ether, ethyl benzyl ether, cresyl methyl ether, anisole and phenetole

In the block copolymerization polyimide composition of the invention, the ester is at least one selected from the group consisting of methyl acetate, ethyl acetate, propyl acetate, isopropyl acetate, butyl acetate, isobutyl acetate, amyl acetate, isoamyl acetate, 2-ethylhexyl acetate, cyclohexyl acetate, methylcyclohexyl acetate, benzyl acetate, methyl acetoacetate, ethyl acetoacetate, methyl propionate, ethyl propionate, butyl propionate, benzyl propionate, methyl butyrate, ethyl butyrate, isopropyl butyrate, butyl butyrate, isoamyl butyrate, methyl lactate, ethyl lactate, butyl lactate, ethyl isovalerate, isoamyl isovalerate, diethyl oxalate, dibutyl oxalate, methyl benzoate, ethyl benzoate, propyl benzoate and methyl salicylate.

In the block copolymerization polyimide composition of the invention, the solvent containing a ketone, an ether or an ester contains at least one selected from the group consisting of N-methylpyrrolidone, N,N-dimethylformamide, N,N-dimethylacetamide and dimethylsulfoxide.

In the block copolymerization polyimide composition of the invention, the lactone is γ-valerolactone, and the base is at least one of pyridine and N-methylmorpholine.

In the block copolymerization polyimide composition of the invention, the block copolymerization polyimide has a weight-average average molecular weight of 10,000 to 200,000 as calculated on a polystyrene basis.

The present invention also provides a positive type photosensitive polyimide composition that comprises a block copolymerization polyimide comprising a tetracarboxylic dianhydride and a diamine and soluble in at least one solvent of an ether, a ketone and an ester and a photooxygenation compound.

The positive type photosensitive block copolymerization polyimide ink composition further comprises a filler that is insoluble in a solvent.

Further, the present invention provides a process of producing a block copolymerization polyimide composition, comprising steps of heating a tetracarboxylic dianhydride and a diamine in a solvent that contains at least one of a ketone, an ether or an ester and in the presence of an acid catalyst generated from a lactone and a base to form a polyimide oligomer, and adding either one of a tetracarboxylic dianhydride or a diamine to said polyimide oligomer for reaction therewith

Furthermore, the present invention provides a process of producing a block copolymerization polyimide composition comprising steps of heating a tetracarboxylic dianhydride and a diamine in a solvent selected from the group consisting of N-methylpyrrolidone, N,N-dimethylformamide, N,N-dimethylacetamide and N,N-dimethylsulfoxide and in the presence of an acid catalyst generated from a lactone and a base to form a polyimide oligomer, then adding either one of a tetracarboxylic dianhydride or a diamine to said polyimide oligomer for reaction therewith, then subjecting the reaction product to precipitation using a poor solvent, filtration and drying, and finally dissolving the resulting product in a solvent comprising at least one of a ketone, an ether and an ester.

According to the invention, it has now been found that with a polyimide composition comprising a specific polyimide and a solvent comprising at least one of a ketone, an ether and an ester, it is possible to form an easy-to-handle polyimide film or other like products that are less affected by ambient moisture and more resistant to whitening or other defects and so have improved properties.

It has also been found that if the starting materials are dissolved in a solvent comprising at least one of a ketone, an ether and an ester or they are allowed to react with each other in other solvent to form a polyimide that is dissolved in a poor solvent upon precipitation, it is then again possible to obtain a solvent-soluble polyimide composition that has improved properties.

Further, it has been found that by making use of an acid catalyst generated from at least either one of γ-valerolactone and a weak base such as pyridine and N-methylmorpholine and consecutive reactions for synthesis, it is possible to gain molecular-level controls of the bonding between the tetracarboxylic dianhydride and the diamine, the degree of polymerization of polyimide, and the physical properties and photosensitization properties of polyimide.

Still further, it has been found that by introducing phenolic hydroxyl groups in the main chain of polyimide in combination with a naphthoquinonediazide that is photooxygenation agent, it is possible to provide a positive type polyimide that is soluble in an alkaline aqueous solution and has high resolution.

Furthermore, it has been found that it is possible to provide a photosensitive polyimide ink and its production process, wherein phenolic hydroxyl groups are introduced in the main chain of polyimide and a photooxygenation agent plus a filler, whereby the polyimide ink is made soluble in an alkaline aqueous solution and a sufficient solubility difference is so created between an exposed portion and an unexposed portion that the polyimide ink is less affected by ambient moisture.

Preferably but no exclusively, the tetracarboxylic dianhydride used for the synthesis of the inventive polyimide includes at least one selected from the group consisting of 3,3',4,4'-biphenyltetracarboxylic dianhydride (BPDA), 3,3',4,4'-benzophenonetetracarboxylic dianhydride (BTDA), 3,3',4,4'-biphenyl ether tetracarboxylic dianhydride (OPDA), 3,3',4,4'-diphenylsulfonetetracarboxylic dianhydirde (DSDA), bicyclo(2,2,2)-oct-7-ene-2,3,5,6-tetracarboxylic dianhydride (BCD), 1,2,4,5-cyclohexanetetracarboxylic dianhydride (H-PMDA), pyromellitic dianhydride (PMDA), 2,2-bis(3,4-dicarboxyphenyl)hexafluoropropane dianhydride (6FDA), and 5-(2,5-dioxotetrahydrofuryl)-3-methyl-3-cyclohexne-1,2-dicarboxylic anhydride (CP).

By way of example but not by way of limitation, the diamine includes at least one selected from the group consisting of siliconediamine, bis(3-aminopropyl)ether ethane, 3,3'-diamino-4,4'-dihydroxydiphenylsulfone (SO2-HOAB), 4,4'-diamino-3,3'-dihydroxybiphenyl (HOAB), 2,2-bis(3-amino-4-hydroxyphenyl)hexafluoropropane (HOCF3AB), siloxanediamine, bis(3-aminopropyl) ether ethane, N,N-bis(3-aminopropyl)ether, 1,4-bis(3-aminopropyl)piperazine, isophoronediamine, 1,3'-bis(aminomethyl)cyclohexane, 3,3'-dimethyl-4,4'-diaminodicylohexylmethane, 4,4'-methylenebis (cyclohexylamine), 4,4'-diaminodiphenyl ether (p-DADE), 3,4'-diaminodiphenyl ether (m-DADE), 3,3-diaminodiphenyl ether, 4,4'-diamino-diphenylsulfone (p-DDS), 3,4'-diaminodiphenylsulfone, 3,3'-diamino-diphenylsulfone, 2,4'-diaminodiphenyl ether, 1,3-bis (4-aminophenoxy) benzene (m-TPE), 1,3-bis (3-aminophenoxy) benzene (APB), 2,2-bis[4-(4-aminophenoxy)phenyl]propane (BAPP), 2,2-bis[4-(4-aminophenoxy)phenyl]hexafluoropropane (HF-BAPP), bis [4-(4-aminophenoxy)phenyl]sulfone (p-BAPS), bis[4-(3-aminophenoxy)phenyl]sulfone (m-BAPS), 4,4'-bis(4-aminophenoxy)biphenyl (BAPB), 1,4-bis (4-aminophenoxy) benzene (p-TPE), 4,4'-diaminodiphenylsulfide (ASD), 3,4'-diaminodiphenylsulfide, 3,3'-diaminodiphenylsulfide, 3,3'-diamino-4,4'-dihydorxydipheylsulfone, 2,4-diaminotoluene (DAT), 2,5-diaminotoluene, 3,5-diaminobenzoic acid (DABz), 2,6-diaminopyridine (DAPy), 4,4'-diamino-3,3'-dimethoxybiphehyl (CH3OAB), 4,4'-diamino-3,3'-dimethylbiphenyl (CH3AB), and 9,9'-bis(4-aminophenyl)fluorene (FDA).

Examples of the siliconediamine are BY16-853U and BY16-853C made by Toray Dow Coning Silicone Co., Ltd., and X-22-16660B-3, KF-8010 and X-22-161A made by the Shin-Etsu Chemical Co., Ltd.

The block copolymerization polyimide in the ketone, ether or ester or a mixed solvent thereof may be prepared by heating the tetracarboxylic dianhydride and diamine in the ketone, ether or ester or a mixed solvent thereof and in the presence of an acid catalyst generated from γ-valerolcatone and a base, thereby subjecting them to dehydration and imide-formation reactions, wherein water formed during the reaction is discharged out of a reaction system by azeotropy with the reaction solvent.

The block copolymerization type polyimide according to the invention may be synthesized by using as the catalyst an acid that is generated from γ-valerolactone and a base selected from pyridine, N-methylmorpholine or the like via such an equilibrium reaction as set forth below.

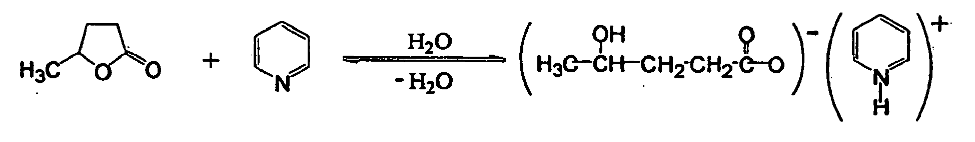

A multicomponent block copolymer may be improved by incorporation of a functional moiety and a structural moiety per molecule in terms of photosensitivity, adhesion, water repellency, mechanical properties, etc. Further, if a solvent-soluble polyimide oligomer is formed through the first-stage reaction, it is then possible to increase the solubility of a polyimide that is less soluble in ketones, ethers or esters or a mixed solvent thereof.

The ketone used herein should have a boiling point of 60°C to 200°C inclusive, because it is required for the polyimide to be easily handled at coating and mixing steps and for the solvent to be easily removable after molding.

Specifically but not exclusively, the ketone used herein includes methyl ethyl ketone, methyl propyl ketone, methyl isopropyl ketone, methyl butyl ketone, methyl isobutyl ketone, methyl n-hexyl ketone, diethyl ketone, diisopropyl ketone, diisobutyl ketone, cyclopentanone, cylcohexanone, methylcyclohexanone, acetylacetone, diacetone alcohol, cyclohexen-1-one, γ-butyrolactone, γ-valerolactone, γ-caprolactone, γ-heptalactone, α-acetyl-γ-butyrolactone, and ε-caprolactone.

Among others, cyclohexanone, methyl ethyl ketone, methyl isobutyl ketone, acetylacetone, diacetone alcohol, cyclohexen-1-one and γ-butyrolactone are preferred because of being general-purpose solvents.

The ether used herein should have a boiling point of 60°C to 200°C inclusive, because it is required for the polyimide to be easily handled at coating and mixing steps and for the solvent to be easily removable after molding.

By way of example but not by way of limitation, such an ether includes dipropyl ether, diisopropyl ether, dibutyl ether, tetrahydrofuran, tetrahydropyran, ethyl isoamyl ether, ethyl-t-butyl ether, ethyl benzyl ether, cresyl methyl ether, anisole, phenetole, diethylene glycol, diethylene glycol dimethyl ether, triethylene glycol dimethyl ether, diethylene glycol diethyl ether, and diethylene glycol dibutyl ether.

Among others, tetrahydrofuran, anisole, phenetole, diethylene glycol dimethyl ether and triethylene glycol dimethyl ether are preferred because of being general-purpose solvents.

Specifically but not exclusively, the ester herein used as the solvent includes at least one selected from the group consisting of methyl acetate, ethyl acetate, propyl acetate, isopropyl acetate, butyl acetate, isobutyl acetate, amyl acetate, isoamyl acetate, 2-ethylhexyl acetate, cyclohexyl acetate, methylcyclohexyl acetate, benzyl acetate, methyl acetoacetate, ethyl acetoacetate, methyl propionate, ethyl propionate, butyl propionate, benzyl propionate, methyl butyrate, ethyl butyrate, isopropyl butyrate, butyl butyrate, isoamyl butyrate, methyl lactate, ethyl lactate, butyl lactate, ethyl isovalerate, isoamyl isovalerate, diethyl oxalate, dibutyl oxalate, methyl benzoate, ethyl benzoate, propyl benzoate and methyl salicylate.

The ketone, ether and ester may be used alone or in admixture, and mixing allows the solubility of the polyimide to be adjusted. The mixing ratio may be determined depending on the desired properties and applications of the polyimide.

In particular, the mixed solvent is more preferred because the polyimide resin composition can stably be used at the coating and drying steps.

Although depending on composition, some polymers are less soluble in the ketone, ether or ester or a ketone-ether mixed solvent. In this case, the solvent may be mixed with N,N-methylpyrrolidone, N,N-dimethylformamide, N,N-dimethylacetamide, dimethylsulfoxide or like other polar solvents in an amount of up to 40% by mass, and preferably 20% by mass per the total amount of all solvents. Such a polar solvent should not be used in an amount of greater than 40% by mass or else whitening or other problems would arise, and should preferably be used in combination with an azeotropic solvent such as toluene.

While the synthesis of polyimide has been described with reference to the use of the ketone, ether or ester or a mixed solvent thereof, it is understood that the polyimide may be prepared only by use of a polar solvent such as N,N-methylpyrrolidone, N,N-dimethylformamide, N,N-dimethylacetamide, and dimethylsulfoxide. After synthesis, the polyimide is precipitated in a poor solvent for its separation, and then the separated polyimide is dissolved in the ketone or ether or a mixed solvent thereof.

Specifically, a polyimide is synthesized in a polar solvent well known as a solvent for polyimides, for instance, N,N-methylpyrrolidone, N,N-dimethylformamide, N,N-dimethylacetamide, or dimethylsulfoxide. In this case, that solvent must be replaced by a ketone or an ether after synthesis; however, this replacement is not easy because those solvents have high boiling points.

Accordingly, the polyimide should be precipitated with a poor solvent such as methanol for removal of the reaction solvent, and procedures used for refinement of normal synthetic resins apply to those steps.

Then, the resin is separated, followed by filtration and drying. The dried block copolymerization polyimide powders are dissolvable in the ketone, ether or ester or a mixed solvent thereof, and the time taken for dissolution may be cut back by heating the solvent to its boiling point or stirring the solvent.

As the molecular weight of polyimide becomes high, the solubility of polyimide in a given solvent becomes low; the weight-average molecular weight of the inventive polyimide soluble in ketones, ethers or esters or their mixed solvents should preferably be in the range of 10,000 to 200,000 as calculated on a polystyrene basis.

When the inventive block copolymerization type polyimide composition is converted to a photosensitive polyimide, a photooxygenation agent that generates an acid upon light irradiation is introduced in that polyimide composition for conversion to a positive type photosensitive polyimide composition.

By way of example but not by way of limitation, the photooxygenation agent to be added to the polyimide solution includes a low-molecular-weight aromatic hydroxy compound such as 1,2-naphthoquinone-2-dizido-5-sulfonic acid ester and 1,2-naphthoquinone-2-diazido-4-sulfonic acid ester, 1,2-naphthoquinone-2-diazido-5-sulfonic acid-o-cresol ester, and 1,2-naphthoquinone-2-diazido-5-sulfonic acid-p-cresol ester.

Such a photooxygenation agent should preferably be used in an amount of 6 to 35% by mass per polyimide solid content, although that amount must be controlled depending on the thickness of the coating film to be formed, etc.

The positive type photosensitive polyimide composition of the invention may be formed in a given polyimide pattern on a support substrate via various steps including coating, prebaking, exposure, development and solvent removal steps. At the coating and prebaking step, the photosensitive polyimide is coated on a substrate such as a semiconductor disk, silicone wafer, germanium, gallium arsenide, glass, ceramic, copper foil or printed substrate by means of a spinner, roll coater, die coater or screen printing, and then prebaked by means of a hot plate or oven.

Then, at the exposure step, a positive type photosensitive composition found in a film form on the support substrate is irradiated with active light rays such as ultraviolet radiation for exposure, thereby forming indene carboxylate at an exposed site, which will make a solubility difference between the exposed site and an unexposed site at the subsequent development step.

At the development step, the exposed portion is removed by means of a developing solution, thereby obtaining a relief pattern. The developer used herein, for instance, includes sodium hydroxide, potassium hydroxide, and tetramethylammonium hydroxide.

Often, the surface of the polyimide after the prebaking step, because of its hydrophobicity, is less compatible with the developer at the development step. In this case, it is acceptable to add to the developer a solvent such as N-methylpyrrolidone, or an alcohol or a surfactant.

The polymer has already been converted to a polyimide at the synthesis stage. At the final heat treatment step, therefore, polyamic acid must usually be dehydrated and converted to an imide at about 350°C after pattern formation. In the process of the invention, however, heat treatment at as low as 250°C could be carried out because only evaporation of the solvent contained in the pattern is needed. Preferably, the heat treatment should be carried out at incremental temperatures of, for instance, 90°C, 120°C, 180°C and 250°C.

The solvent-insoluble filler to be mixed with an ink comprising the inventive polyimide, for instance, includes an inorganic filler selected from fumed silica, spherical silica, amorphous silica, milled fiber, titanium dioxide, barium sulfate, calcium carbonate, magnesium oxide and carbon black, a synthetic resin filler selected from fluororesin, polyethylene resin, polypropylene resin, crosslinked styrene, epoxy resin and polyimide resin, and an organic pigment selected from phthalocyanine blue, phthalocyanine green, isoindolinone yellow greenish, isoindolinone yellow redish and quinacridone.

The amount of the filler added is preferably in the range of 0.05 to 95% by mass per polyimide solid content. More preferably, fumed silica is used in an amount of 0.05 to 15% by mass per polyimide solid content. Spherical silica, amorphous silica, milled fiber, titanium dioxide, barium sulfate, calcium carbonate, magnesium oxide, and carbon black is used in an amount of 1 to 50% by mass per polyimide solid content.

The synthetic resin filler is used in an amount of preferably 1 to 50% by mass per polyimide solid content, and the organic pigment is used in an amount of 0.05 to 10% by weight per polyimide solid content.

At a printing process, the positive type photosensitive polyimide ink is printed all over the surface of an application member using a metal mask, screen stencil or metal mesh. Then, an image is exposed to ultraviolet radiation of 365 to 436 nm through a given photomask, and the thus irradiated area is removed by an alkaline aqueous solution so that a pattern can be formed.

When a film is formed by screen printing, it is preferable to use a clearance of about 1/300 of the internal size of a screen frame, a squeegee pressure of 100 to 300 g/cm², a squeegee angle of 65 to 75° and a squeegee rate of 40 to 150 mm/sec.

### Example 1-1

Four point four one (4.41) grams (15 mmoles) of 3,4,3',4'-biphenyltetracarboxylic dianhydride (made by Ube Kosan Co., Ltd. with a molecular weight of 294.25; hereinafter BPDA for short), 12.32 grams (30 mmoles) of 2,2-bis[4-(4-aminophenoxy)phenyl]propane (made by Wakayama Seika Co., Ltd. with a molecular weight of 410.5; hereinafter BAPP for short), 0.15 gram (1.5 mmoles) of γ-valerolactone and 2.4 grams of (3 mmoles) of pyridine, both acting together as a catalyst, and 64.75 grams of a solvent anisole were provided as a starting feed.

First, the starting feed was stirred at 25°C and 100 rpm for 0.5 hour in a nitrogen atmosphere into a homogeneous solution, which was in turn heated to 180°C in an oil bath, where the solution was stirred at 180 rpm for a further one hour. During the resulting reaction, azeotropic water was removed.

After the completion of the first-stage reaction, the reaction product was cooled down to 25°C, and 8.83 grams (30 mmoles) of fresh BPDA, 13.80 grams (15 mmoles) of siliconediamine (By16-853U made by Toray Dow Coning Co., Ltd.) and 150 grams of a fresh solvent anisole were provided thereto. The solution was stirred at 25°C and 100 rpm for about 1 hour, and then heated to 180°C in an oil bath for 2 hours 45 minutes for reaction, during which the ensuing water was removed for each 1 hour.

The obtained polyimide solution was found to have a polymer concentration of 15% by mass. As measured by gel permeation chromatography (GPC), the polyimide was found to have a number-average molecular weight (Mn) of 9,225, a weight-average molecular weight (Mw) of 21,437 and a Z-average molecular weight (Mz) of 37,515 as calculated on a polystyrene basis, with Mw/Mn=2.32 and Mz/Mn=4.07.

### Example 1-2

Five point eight eight (5.88) grams (20 mmoles) of BPDA, 9.20 grams (10 mmoles) of siliconediamine (By16-853U made by Toray Dow Coning Co., Ltd. with an amine equivalent of 460), and 0.3 gram (3 mmoles) of γ-valerolactone and 0.47 gram of (6 mmoles) of pyridine, both acting together as a catalyst, 40 grams of a solvent anisole and 11 grams of N-methylpyrrolidone (NMP) were provided as a starting feed. First, the starting feed was stirred at 25°C and 100 rpm for 0.5 hour in a nitrogen atmosphere into a homogeneous solution, which was in turn heated to 180°C in an oil bath, where the solution was stirred at 180 rpm for a further one hour. During the resulting reaction, azeotropic water was removed.

After the completion of the first-stage reaction, the reaction product was cooled down to 25°C, and 2.48 grams (10 mmoles) of bicyclo[2,2,2]octa-2-ene-2,3,5,6-tetracarboxylic dianhydride (made by Aldrich Co., Ltd. with a molecular weight of 248.19; hereinafter BCD for short), 3.41 grams (20 mmoles) of isophoronediamine (made by Tokyo Kasei Co., Ltd. with a molecular weight of 170.25) and 39.56 grams of a fresh solvent anisole were provided thereto. The solution was stirred at 25°C and 100 rpm for about 1 hour, and then heated to 180°C in an oil bath for 4 hours for reaction, during which the ensuing water was removed per 1 hour.

The obtained polyimide solution was found to have a polymer concentration of 18% by mass. As measured by gel permeation chromatography (GPC), the polyimide was found to have a number-average molecular weight (Mn) of 11,481, a weight-average molecular weight (Mw) of 24,431 and a Z-average molecular weight (Mz) of 39,756 as calculated on a polystyrene basis, with Mw/Mn=2.13 and Mz/Mn=3.38.

### Example 1-3

Ten point five seven (10.57) grams (40 mmoles) of 5-(2,5-dioxotetrahydrofuryl)-3-methyl-3-cyclohexene-1,2-dicarboxylic anhydride (made by Tokyo Kasei Co., Ltd. with a molecular weight of 264.23; hereinafter CP acid for short), 8.65 grams (20 mmoles) of bis[4-(3-aminophenoxy)phenyl]sulfone (made by Wakayama Seika Co., Ltd. with a molecular weight of 432.5; hereinafter m-BAPS for short), and 0.4 gram (4 mmoles) of γ-valerolactone and 0.63 gram of (8 mmoles) of pyridine, both acting together as a catalyst, and 20 grams of a solvent cyclohexanone were provided as a starting feed. First, the starting feed was stirred at 25°C and 100 rpm for 0.5 hour in a nitrogen atmosphere into a homogeneous solution, which was in turn heated in an oil bath at 180°C, where the solution was stirred at 180 rpm for a further one hour. During the resulting reaction, azeotropic water was removed.

After the completion of the first-stage reaction, the reaction product was cooled down to room temperature, and 8.21 grams (20 mmoles) of a fresh BAPP and 40.64 grams of a fresh solvent cyclohexanone were provided thereto. The solution was stirred at 25°C and 100 rpm for about 1 hour, and then heated to 180°C in an oil bath, where it was stirred at 180 rpm for 2 hours for reaction, during which the ensuing water was removed per 1 hour.

The obtained polyimide solution was found to have a polymer concentration of 30% by mass. As measured by gel permeation chromatography (GPC), the polyimide was found to have a number-average molecular weight (Mn) of 7,042, a weight-average molecular weight (Mw) of 11,574 and a Z-average molecular weight (Mz) of 17,551 as calculated on a polystyrene basis, with Mw/Mn=1.64 and Mz/Mn=2.49.

### Example 1-4

Thirty five point three one (35.31) grams (120 mmoles) of BPDA, 55.54 grams (60 mmoles) of siliconediamine (By16-853U made by Toray Dow Coning Co., Ltd. with an amine equivalent of 460), and 1.8 grams (18 mmoles) of γ-valerolactone and 2.85 gram of (36 mmoles) of pyridine, both acting together as a catalyst, and 150 grams of N-methylpyrrolidone (NMP) and 40 grams of toluene were provided as a starting feed, which was then stirred at 25°C and 100 rpm for 0.5 hour in a nitrogen atmosphere into a homogeneous solution, which was in turn heated to 180°C in an oil bath, where the solution was stirred at 180 rpm for a further one hour. During the resulting reaction, an azeotropic component of toluene and water was removed.

After the completion of the first-stage reaction, the reaction product was cooled down to room temperature, and 17.65 grams (60 mmoles) of a fresh BPDA, 27.60 grams (30 mmoles) of siliconediamine (By16-853U made by Toray Dow Coning Co., Ltd.), 12.01 grams (60 mmoles) of 3,4'-diaminodiphenyl ether (made by Wakayama Seika Co., Ltd. with a molecular weight of 200.2; hereinafter m-DADE for short), 8.77 grams (30 mmoles) of 1,3-bis(4-aminophenoxy) benzene (made by Wakayama Seika Co., Ltd. with a molecular weight of 292.34; hereinafter m-TPE for short), 200 grams of a fresh solvent N-methylpyrrolidone (NMP) and 30 grams of a fresh toluene were provided thereto. The solution was stirred at 25°C and 100 rpm for 1 hour, and then heated to 180°C in an oil bath for 4 hours 30 minutes for reaction, during which the ensuing azeotropic product of toluene and water was removed per 1 hour.

The obtained polyimide solution was found to have a polymer concentration of 30% by mass.

The obtained polyimide solution was cooled down to 25°C. Then, while stirring was carried out, the solution was mixed with small portions of methanol, and the resultant polyimide precipitate was comminuted. The resultant polyimide powders were washed three times with methanol, and subjected to suction filtration. Using a vacuum drier, the thus obtained polyimide powders were dried at 25°C for 3 hours, 60°C for a further one hour, and 90°C for a further one hour.

The dried polyimide powders were agitated at 25°C for 30 minutes with the addition of anisole thereto until a solid content of 24% by mass was obtained. A most part of the powders was found to stay in a powdery form although only a small portion thereof was dissolved. A 30-minute agitation at an elevated temperature of 100°C enabled the polyimide powders to be dissolved in anisole, yielding a homogeneous solution, which was found to keep fluidity even upon cooled down to 25°C. As measured by gel permeation chromatography (GPC), the polyimide was found to have a number-average molecular weight (Mn) of 13,890, a weight-average molecular weight (Mw) of 31,456 and a Z-average molecular weight (Mz) of 47,203 as calculated on a polystyrene basis, with Mw/Mn=2.26 and Mz/Mn=3.39.

Even after a lapse of 2 weeks, there was no increase in the viscosity of the polyimide solution; that solution kept still fluidity. In an environment having a temperature of 25°C and a relative humidity of 60%, this solution was used to make a screen printing ink. While a three-roll arrangement is used to mix a filler with a polyimide vanish by roll milling, the polyimide is highly sensitive to atmospheric moisture because the surface area of the polyimide coming into contact with the air increases. When anisole that is a sort of ether is used as in the present invention, however, the polyimide is hardly affected by atmospheric moisture during roll milling. Even 40 minutes after exposure of the inventive polyimide to air, there was no whitening of its surface.

### Example 1-5

Twenty five point seven eight (25.78) grams (80 mmoles) of 3,4,3',4'-benzophenonetetracarboxylic dianhydride (a product made by Jayhawk Fine Chemicals Co., Ltd. with a molecular weight of 322.23; hereinafter BTDA for short), 6.81 grams (40 mmoles) of isophoronediamine, and 1.20 grams (12 mmoles) of γ-valerolactone and 1.90 grams (24 mmoles) of pyridine, both acting together as a catalyst, and 100 grams of a solvent N-methylpyrrolidone and 30 grams of a solvent toluene were provided as a starting feed, which was then stirred at 25°C and 100 rpm for 30 minutes in a nitrogen atmosphere into a homogeneous solution. The solution was heated to 180°C, followed by stirring at 180 rpm for 1 hour. During the reaction, the resultant water and the ensuing azeotropic component of water and toluene were removed.

The solution was cooled down to 25°C, and 34.6 grams (80 mmoles) of m-BAPS, 9.05 grams (40 mmoles) of cyclohexane-1,2,4,5-tetracarboxylic dianhydride (made by Shin-Nippon Rika Co., Ltd. with a molecular weight of 226.25; hereinafter H-PMDA for short), 115.76 grams of a solvent N-methylpyrrolidone and 30 grams of toluene were added thereto, followed by a one-hour stirring at 25°C and, then, a three-hour stirring at 180°C and 180 rpm in an oil bath. The thus obtained polyimide solution was found to have a polymer concentration of 25% by mass.

The obtained polyimide solution was cooled down to 25°C, and small portions of methanol were added thereto under agitation. The obtained polyimide precipitate was comminuted in a mixer, and the resulting polyimide powders were filtrated and washed three times with methanol. The thus obtained polyimide powders were dried at room temperature for 3 hours, 60°C for a further one hour, and 90°C for a further one hour.

The dried polyimide powders were agitated at 25°C for 30 minutes with the addition of cyclohexanone thereto until a solid content of 20% by mass was obtained. A most part of the powders was found to stay in a powdery form although only a small portion thereof was dissolved. A 30-minute agitation at an elevated temperature of 100°C enabled the polyimide powders to be dissolved in the solvent, yielding a homogeneous solution.

As measured by gel permeation chromatography (GPC), the obtained polyimide was found to have a number-average molecular weight (Mn) of 18,664, a weight-average molecular weight (Mw) of 102,276 and a Z-average molecular weight (Mz) of 325,769 as calculated on a polystyrene basis, with Mw/Mn=5.47.

Then, the polyimide solution was coated on a stainless steel plate by means of a spinner, and allowed to stand alone in the air. Even after a lapse of 30 minutes, there was no whitening of the surface of the polyimide film.

### Comparative Example 1-1

In Example 1-4, the three-roll arrangement was used to subject the solution of the polyimide in N-methylpyrrolidone to roll milling with no separation of the powdery polyimide from the N-methylpyrrolidone solution. During roll milling, the polyimide was affected by atmospheric moisture due to an increase in its surface area coming into contact with the air, and after a lapse of 10 minutes, the surface of the polyimide was whitened.

### Comparative Example 1-2

In Example 1-5, the three-roll arrangement was used to subject the solution of the polyimide in N-methylpyrrolidone to roll milling with no separation of the powdery polyimide from the N-methylpyrrolidone solution. During roll milling, the polyimide was affected by atmospheric moisture due to an increase in its surface area coming into contact with the air; after a lapse of 5 minutes, the surface of the polyimide became white little by little from its periphery, resulting in whitening of the whole surface after a lapse of 10 minutes.

### Example 2-1

Charged in a four-necked flask having a stirrer, a ball-equipped condenser and a nitrogen inlet pipe were 14.88 grams (60 mmoles) of BCD, 6.00 grams (30 mmoles) of 4,4'-diaminodiphenyl ether (made by Wakayama Seika Co., Ltd. with a molecular weight of 200.00; hereinafter p-DADE for short), and 0.9 gram (9 mmmoles) of γ-valerolactone and 1.44 grams (18 mmoles) of pyridine, both acting together as a catalyst, and a solvent γ-butyrolactone. Thirty (30) grams of toluene were added as a dehydrator to a reaction system. First, the reaction system was stirred at room temperature and 100 rpm for 10 minutes in a nitrogen atmosphere to dissolve the monomers into a homogeneous solution, which was in turn heated in an oil bath of 180°C, and stirred at 180 rpm for 1 hour, during which azeotropic water was removed. After a 180 rpm, 180°C reaction, the first-stage reaction was stopped. A sample was taken out of the reaction product for the purpose of molecular weight measurement, and subjected to gel permeation chromatography. As a result, the sample was found to have a weight-average molecular weight of 4,300 with a molecular weight distribution (Mw/Mn) of 1.8.

After the flask was cooled down to an internal temperature of 60°C, 6.00 grams (30 mmoles) of m-DADE and 10.87 grams (30 mmoles) of 2,2-bis[4-(4-aminophenoxy) phenyl]hexafluoropropane (made by Central Glass Co., Ltd. with a molecular weight of 362.33; hereinafter HOCF3AB for short) were added to the reaction product for homogeneous dissolution of the diamine. Then, 8.82 grams (30 mmoles) of BPDA were added together with a solvent γ-butyrolactone to the solution, and finally 30 grams of a dehydrator toluene were placed in the flask.

Then, the solution was stirred at 25°C and 100 rpm for 1 hour, and heated to 180°C in an oil bath, where it was stirred at 180 rpm for 2 hours 45 minutes for reaction, during which the resultant water was removed for each hour.

The obtained polyimide solution was found to have a polymer concentration of 20% by mass. As measured by gel permeation chromatography (GPC), the polyimide was found to have a number-average molecular weight (Mn) of 9,225, a weight-average molecular weight (Mw) of 21,437 and a Z-average molecular weight (Mz) of 37,515, with Mw/Mn=2.32 and Mz/Mn=4.07, as calculated on a polystyrene basis.

A photooxygenation agent 1,2-naphthoquinone-2-diazido-5-sufonic acid ester (made by Toyo Synthesis Industries, Ltd.; hereinafter PC5 for short) was added to the obtained block copolymerization type polyimide solution in an amount of 20% by mass relative to polyimide solid content, which was then filtrated through a 0.3 µm filter under pressure to obtain a positive type photosensitive polyimide composition.

In an environment having a relative humidity of 80%, the obtained positive type photosensitive polyimide composition was coated on a silicon wafer by means of a rotary spinner, so that a uniform film with no sign of whitening could be formed. Subsequently, the film was prebaked on a hot plate at 90°C for 10 minutes to obtain a 6.5 µm film, which was in turn exposed to light at a varying exposure of 400 to 800 mJ/cm² by way of a resolution-measuring mask.

Then, using a 5% by mass solution of tetramethylammonium hydroxide as a developing solution, paddle development was carried out at room temperature for 7 minutes, followed by rinsing with pure water, yielding a relief pattern.

The obtained pattern was observed under a scanning electron microscope. A sensitivity to 10 µmL/S was 700 mJ/cm². The obtained relief pattern was dried and heat treated at three stages, say, 120°C, 180°C and 250°C, each for 20 minutes, by means of a hot-air drier, so that a satisfactory polyimide film pattern could be obtained. The rate of film remaining at an unexposed site was 78%.

### Examples 2-2 to 2-8

A block copolymerization type polyimide composition was prepared as in Example 2-1 with the exception that the tetracarboxylic dianhydride and diamine for the first-stage reaction and the tetracarboxylic dianhydride and diamine for the second-stage reaction were changed to those shown in Table 1, respectively. Then, a positive type photosensitive polyimide composition was prepared and estimated as in Example 2-1. The results are shown in Table 1.

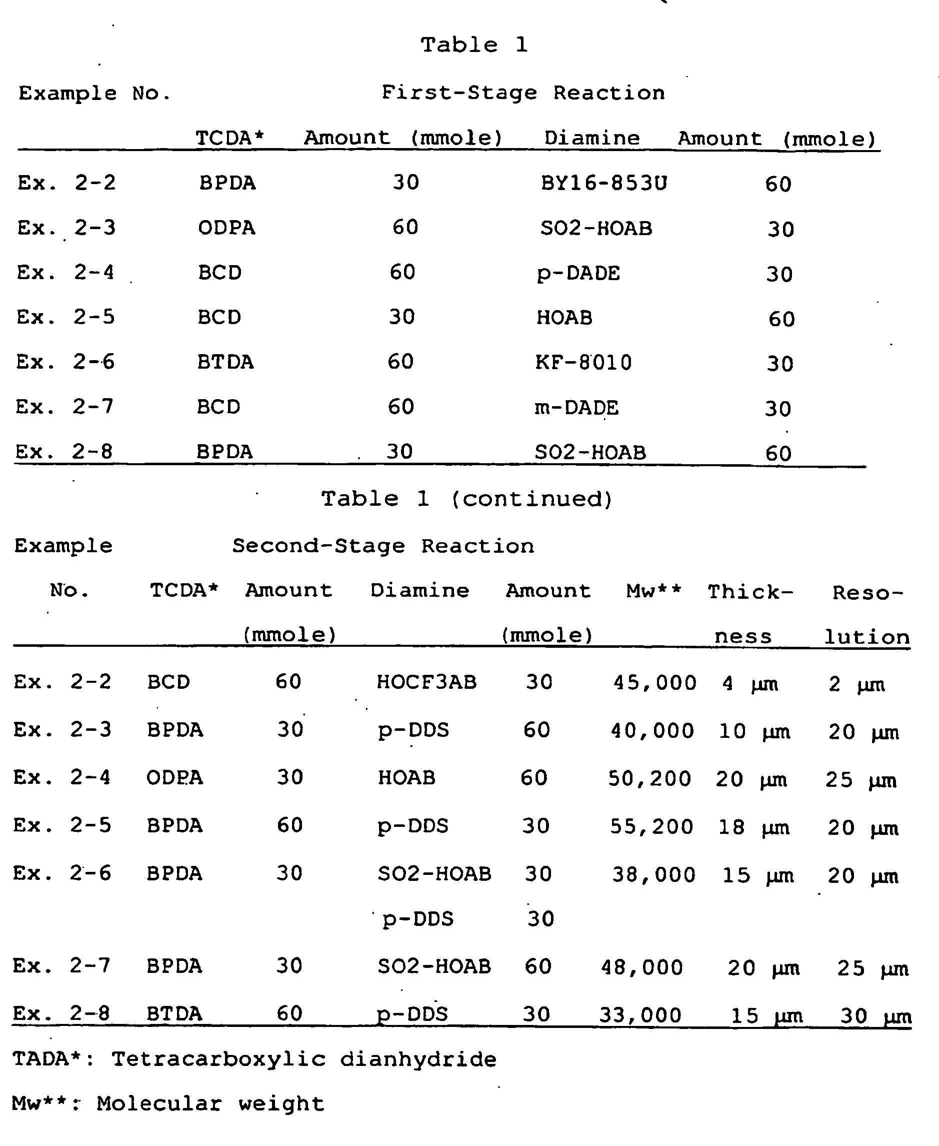

### Example 3-1

Charged in a four-necked flask having a stirring rod, a ball-equipped condenser and a nitrogen inlet pipe were 14.88 grams (60 mmoles) of BCD, 6.00 grams (30 mmoles) of p-DADE, and 0.9 gram (9 mmoles) of γ-valerolactone and 1.44 grams (18 mmoles) of pyridine, both acting together as a catalyst, and a solvent γ-butyrolactone.

For azeotropic removal of water, 30 grams of toluene were added as a dehydrator to a reaction system.

First, the reaction system was stirred at 25°C ad 100 rpm for 10 minutes in a nitrogen atmosphere to dissolve the monomers into a homogeneous solution, which was in turn heated to 180°C in an oil bath, and stirred at 180 rpm for 1 hour, during which azeotropic water was removed.

After a 180 rpm, 180°C reaction, the first-stage reaction was stopped. A sample was taken out of the reaction product for the purpose of molecular weight measurement, and subjected to gel permeation chromatography. As a result, the sample was found to have a weight-average molecular weight of 4,300 with a molecular weight distribution (Mw/Mn) of 1.8.

After the flask was cooled down to an internal temperature of 60°C, the second-stage reaction was initiated; 6.00 grams (30 mmoles) of m-DADE and 10.87 grams (30 mmoles) of HO-CF₃-AB were added to the reaction product for homogeneous dissolution of the diamine. Then, 8.82 grams (30 mmoles) of biphenyltetracarboxylic dianhydride (made by Ube Kosan Co., Ltd. with a molecular weight of 294.33; hereinafter BPDA for short) were added together with a solvent γ-butyrolactone to the solution, and finally 30 grams of toluene were placed in the flask.

Then, the solution was stirred at 25°C and 100 rpm for 1 hour, and heated in an oil bath of 180°C, where it was stirred at 180 rpm for 2 hours 45 minutes for reaction, during which the resultant water was removed for each hour.

The obtained polyimide solution was found to have a polymer concentration of 20% by mass. As measured by gel permeation chromatography, the polyimide was found to have a number-average molecular weight (Mn) of 9,225, a weight-average molecular weight (Mw) of 21,437 and a Z-average molecular weight (Mz) of 37,515, with Mw/Mn=2.32 and Mz/Mn=4.07, as calculated on a polystyrene basis.

Fumed silica (R-200 made by Nippon Aerosil Co., Ltd.) was added to the obtained block copolymerization polyimide solution in an amount of 1.0% by mass relative to polyimide resin for full-mixing with a three-roll arrangement. Subsequently, a photooxygenation agent 1,2-naphthoquinone-2-diazido-5-sufonic acid ester (made by Toyo Synthesis Industries, Ltd.; hereinafter PC5 for short) was added to the block copolymerization polyimide solution in an amount of 20% by mass relative to polyimide solid content to obtain a positive type photosensitive polyimide ink.

The obtained positive type photosensitive polyimide composition ink was used on a 400-mesh screen printing plate to form a photosensitive film on a wafer at a squeegee rate of 10 mm/sec., and the film was prebaked on a hot plate at 90°C for 10 minutes to obtain a 6.5 µm film, which was then exposed to ultraviolet radiation at an exposure of 800 mJ/cm² by way of a mask.

Then, using a 5% by mass aqueous solution of tetramethyl-ammonium hydroxide as a developing solution, development was carried out at room temperature for 7 minutes, followed by rinsing with pure water, yielding a relief pattern. The obtained relief pattern was dried at three stages, say, 120°C, 180°C and 250°C, each for 20 minutes, by means of a hot-air drier. Observation of the relief pattern under a scanning electron microscope showed that a 1 µm line-and-space pattern was obtained. The rate of film remaining at an unexposed site was then 78%.

### Examples 3-2 to 3-10

As in Example 3-1, polyimide oligomers comprising the tetracarboxylic dianhydrides and diamines shown in Table 2 were prepared. Subsequently, the tetracarboxylic dianhydrides and diamines shown in Table 3 were added to the polyimide oligomers to prepare block copolymerization type polyimide solutions. The molecular weights of the obtained polyimides are shown in Table 2.

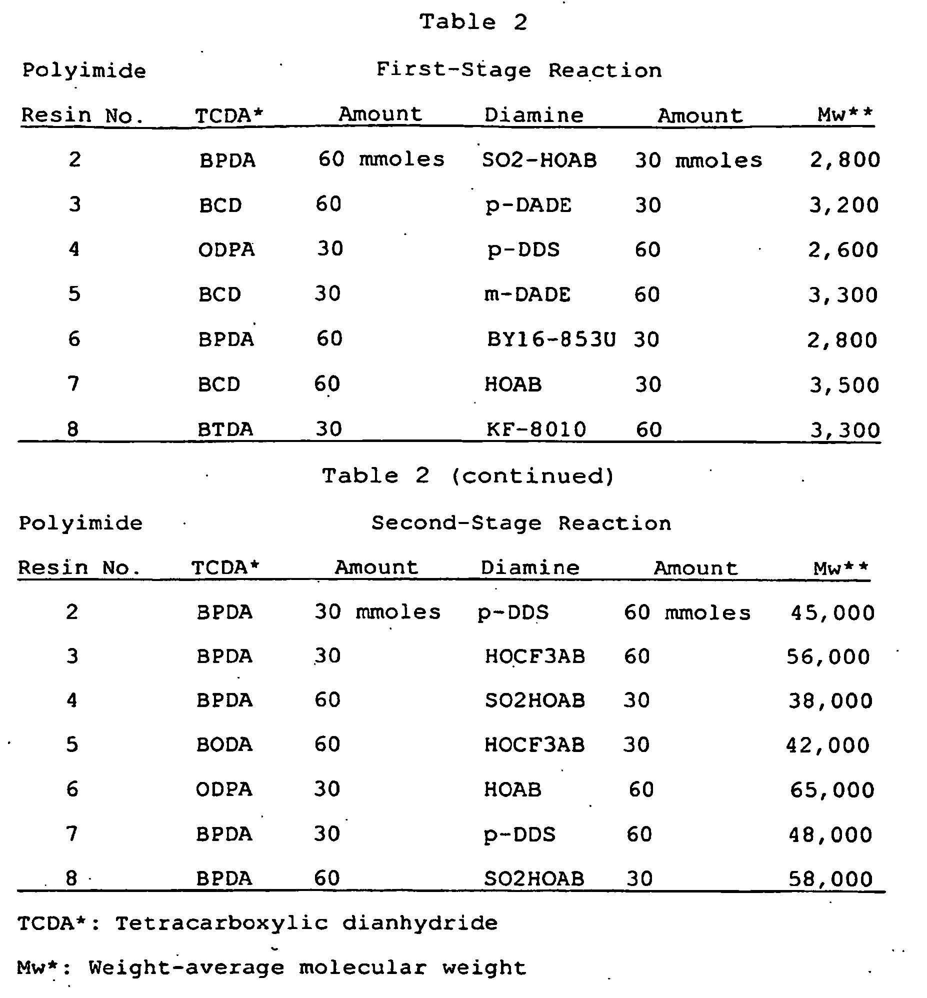

The fillers shown in Table 3 were each added to the obtained block copolymerization polyimide solution in an amount of 1.0% by mass for mixing with a three-roll arrangement. Subsequently, a photooxygenation agent 1,2-naphthoquinone-2-diazido-5-sufonic acid ester (made by Toyo Synthesis Industries, Ltd.) was added to the block copolymerization polyimide solution in an amount of 20% by mass relative to polyimide solid content to obtain a positive type photosensitive polyimide composition ink as shown in Table 3.

In a room having a relative humidity of 80%, the obtained positive type photosensitive polyimide composition ink was used on a 400-mesh screen printing plate to form a photosensitive film on a copper foil at a squeegee rate of 10 mm/sec., and the film was prebaked on a hot plate at 90°C for 10 minutes to obtain a 6.5 µm thick film, which was then exposed to ultraviolet radiation at an exposure of 800 mJ/cm² by way of a resolution-measuring mask. Then, using a 5% by mass aqueous solution of sodium hydroxide as a developing solution, development was carried out at 25°C for 5 minutes, followed by rinsing with pure water. The obtained relief pattern was then dried at three stages, say, 120°C, 180°C and 250°C, each for 20 minutes, by means of a hot-air drier.

Observation of the relief pattern under a scanning electron microscope showed that a satisfactory line-and-space pattern was obtained. The resolutions at which good line-and-space patterns could be obtained are shown in Table 3.

In Table 3, it is noted that silica products obtained by wet processes are designated in terms of number base particle diameter.

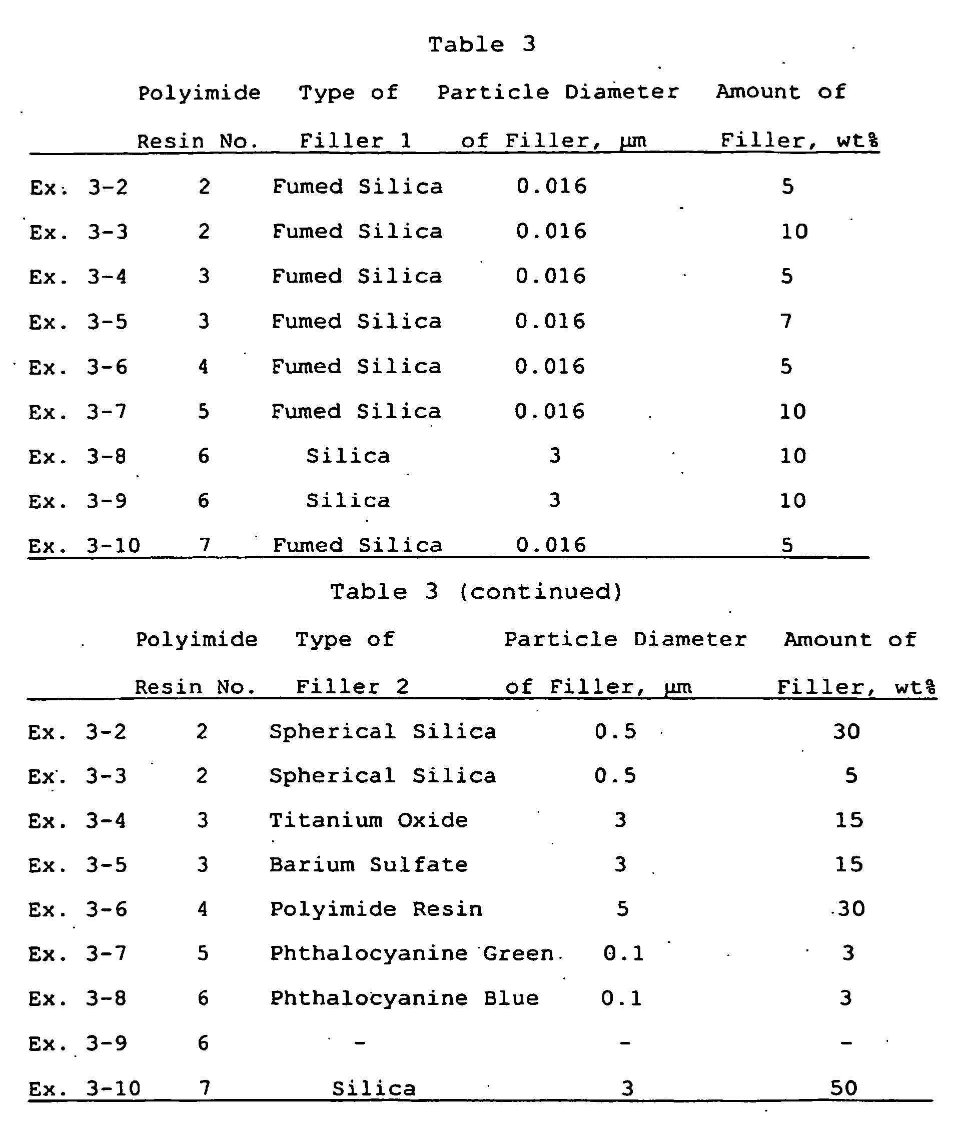

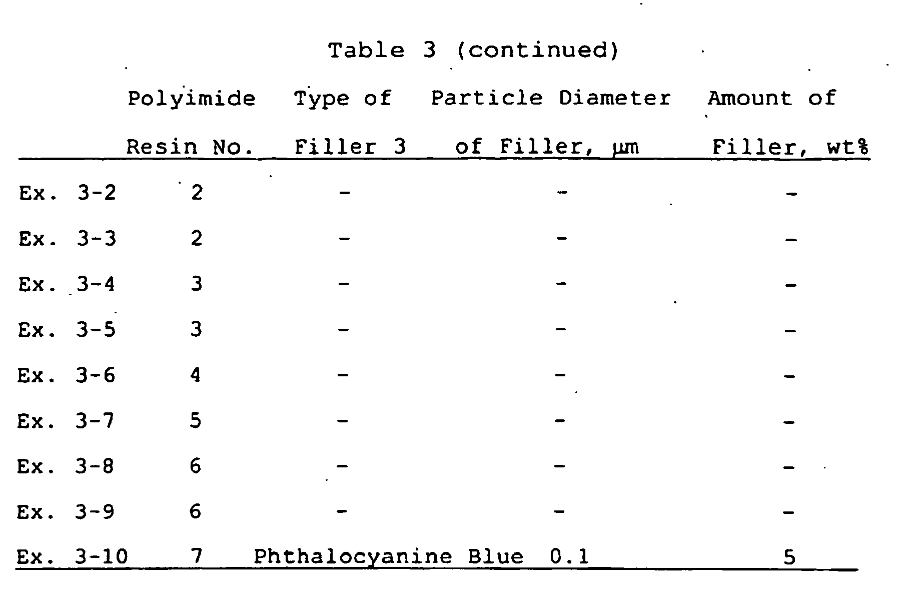

### Example 3-11

Thirty seven point two three (37.23) grams (120 mmoles) of 3,3',4,4'-biphenyl ether tetracarboxylic dianhydride (made by Manack Co., Ltd.; hereinafter ODPA for short), 53.64 grams (60 mmoles) of diaminosiloxane (Lot No. By16-853U made by Toray Dow Coning Silicone Co., Ltd. with an amine equivalent of 447), and 1.2 grams (12 mmoles) of γ-valerolactone and 1.9 grams (24 mmoles) of pyridine, both acting together as a catalyst, 166 grams of a solvent ethyl benzoate (hereinafter BAEt for short), 40 grams of a solvent γ-butyrolactone and 40 grams of a dehydration aid toluene were provided as a starting feed.

First, the starting feed was stirred at 25°C and 100 rpm for 0.5 hour in a nitrogen atmosphere, and heated to 180°C in an oil bath, where it was stirred at 180 rpm for a one-hour reaction, during which the resultant water was removed.

The obtained imide oligomer was found to have a number-average molecular weight (Mn) of 2,133 and a weight-average molecular weight (Mw) of 3,200, with Mw/Mn=1.5.

After the completion of the first-stage reaction, the reaction solution was cooled down to 25°C with the introduction of 6.01 grams (30 mmoles) of m-DADE, 8.41 grams (30 mmoles) of 3,3'-diamino-4,4'-dihydroxydiphenylsulfone (made by Konishi Chemicals Co., Ltd. with a molecular weight of 280.3; hereinafter S02-HOAB for short), 30 grams of a solvent γ-butyrolactone and 30 grams of toluene. After the reaction system was stirred at room temperature and 100 rpm for about 1 hour, the bath was heated to 180°C, at which the reaction system was stirred at 180 rpm for 3 hours, during which the resultant water was removed.

The obtained polyimide solution was found to have a polymer concentration of 30% by mass. As measured by gel permeation chromatography (CPS), the polyimide was found to have a number-average molecular weight (Mn) of 28,571 and a weight-average molecular weight (Mw) of 60,000, with Mw/Mn=2.1, as calculated on a polystyrene basis.

Then, fumed silica (R-200 made by Nippon Aerosil Co., Ltd.) that was an inorganic filler was added to the obtained polyimide vanish in an amount of 10% by mass relative to polyimide solid content for full mixing with a three-roll arrangement, followed by addition of 1,2-naphthoquinone-2-diazido-5-sulfonic acid ester (NT200 made by Toyo Synthesis Industries, Ltd.) in an amount of 15% by mass relative to polyimide solid content, thereby preparing a positive type photosensitive polyimide ink.

In a clean room at a temperature 24°C and a relative humidity of 60%, the obtained positive type photosensitive polyimide ink was used on a 300-mesh screen printing plate to form a photosensitive film on a 35 µm copper foil at a squeegee rate of 20 mm/sec., following which the film was left for about 10 minutes for leveling. In the meantime, any whitening due to absorption of moisture was not found on the surface of the polyimide film.

Then, the film was prebaked at 90°C for 40 minutes in a hot-air circulation drier to obtain an 8 µm thick film, which was then exposed to ultraviolet radiation at an exposure of 600 mJ/cm² by way of a resolution-measuring mask.

Then, using a 3% by mass aqueous solution of sodium hydroxide as a developing solution, development was carried out at 40°C for 2.5 minutes, followed by rinsing with pure water. The obtained relief pattern was then dried at three stages, say, 120°C, 180°C and 250°C, each for 20 minutes, by means of a hot-air circulation drier. Observation of the obtained relief pattern under a scanning electron microscope showed that a satisfactory pattern was obtained.

### Comparative Example 2-1

Charged in a four-necked flask having a stirring rod, a ball-equipped condenser and a nitrogen inlet pipe were 14.88 grams (60 mmoles) of BCD, 6.00 grams (30 mmoles) of p-DADE, and 0.9 gram (9 mmoles) of γ-valerolactone and 1.44 grams (18 mmoles) of pyridine, both acting together as a catalyst, and a solvent N-methylpyrrolidone.

For azeotropic removal of water, 30 grams of toluene were added as a dehydrator to a reaction system. First, the reaction system was stirred at 25°C and 100 rpm for 10 minutes in a nitrogen atmosphere to dissolve the monomers into a homogeneous solution, which was in turn heated to 180°C in an oil bath, and stirred at 180 rpm for 1 hour, during which azeotropic water was removed.

A sample was taken out of the reaction product for the purpose of molecular weight measurement, and subjected to gel permeation chromatography. As a result, the sample was found to have a weight-average molecular weight of 3,800 with a molecular weight distribution (Mw/Mn) of 1.88.

Upon the flask cooled down to an internal temperature of 60°C, the second-stage reaction was initiated; 6.00 grams (30 mmoles) of m-DADE and 10.87 grams (30 mmoles) of HO-CF₃-AB were added to the reaction product for homogeneous dissolution of the diamine. Then, 8.82 grams (30 mmoles) of BPDA were added together with a solvent γ-butyrolactone to the solution, and finally 30 grams of a dehydrator toluene were added thereto for azeotropic removal of water.

Then, the solution was stirred at 25°C and 100 rpm for 1 hour, and heated to 180°C in an oil bath, at which it was stirred at 180 rpm for 2 hours 45 minutes for reaction, during which the resultant water was removed for each hour.

The obtained polyimide solution was found to have a polymer concentration of 20% by mass. As measured by gel permeation chromatography (GPC), the polyimide was found to have a number-average molecular weight (Mn) of 22,350 and a weight-average molecular weight (Mw) of 49,000, with Mw/Mn=2.19, as calculated on a polystyrene basis.

In an environment having a relative humidity of 80%, fumed silica (R-200 made by Nippon Aerosil Co., Ltd.) was added to the obtained block copolymerization polyimide solution in an amount of 1.0% by mass relative to polyimide resin for mixing with a three-roll arrangement However, no homogeneous ink was obtained due to whitening.

### Comparative Example 2-2

Charged in a four-necked flask having a stirring rod, a ball-equipped condenser and a nitrogen inlet pipe were 14.88 grams (60 mmoles) of BCD, 6.00 grams (30 mmoles) of p-DADE, and 0.9 gram (9 mmoles) of γ-valerolactone and 1.44 grams (18 mmoles) of pyridine, both acting together as a catalyst, and a solvent N-methylpyrrolidone. For azeotropic removal of water, 30 grams of toluene were added to a reaction system.

First, the reaction system was stirred at room temperature and 100 rpm for 10 minutes in a nitrogen atmosphere to dissolve the monomers into a homogeneous solution, which was in turn heated in an oil bath of 180°C, and stirred at 180 rpm for 1 hour, during which azeotropic water was removed. After a 180°C, 180 rpm reaction, the first-stage reaction was stopped. A sample was taken out of the reaction product for the purpose of molecular weight measurement, and subjected to gel permeation chromatography. As a result, the sample was found to have a weight-average molecular weight of 3,800 with a molecular weight distribution (Mw/Mn) of 1.88.

Upon the flask cooled down to an internal temperature of 60°C, the second-stage reaction was initiated; 6.00 grams (30 mmoles) of m-DADE and 10.87 grams (30 mmoles) of HO-CF₃-AB were added to the reaction product for homogeneous dissolution of the diamine. Then, 8.82 grams (30 mmoles) of 3,3',4,4'-biphenyltetracarboxylic dianhydride (made by Ube Kosan Co., Ltd. with a molecular weight of 294.33; hereinafter BPDA for short) were added together with a solvent γ-butyrolactone to the solution, and finally 30 grams of toluene were added thereto for azeotropic removal of water.

Then, the solution was stirred at 25°C and 100 rpm for 1 hour, and heated to 180°C in an oil bath, at which it was stirred at 180 rpm for 2 hours 45 minutes for reaction, during which the resultant water was removed for each hour.

The obtained polyimide solution was found to have a polymer concentration of 19.5% by mass. As measured by gel permeation chromatography (GPC), the polyimide was found to have a number-average molecular weight (Mn) of 25,300 and a weight-average molecular weight (Mw) of 53,200, with Mw/Mn=2.10, as calculated on a polystyrene basis.

At a relative humidity of 20%, fumed silica (R-200 made by Nippon Aerosil Co., Ltd.) was added to the block copolymerization polyimide solution in an amount of 1.0% by mass relative to polyimide resin for full-mixing with a three-roll arrangement. In this case, uniform mixing was achievable. Subsequently, 1,2-naphthoquinone-2-diazido-5-sulfonic acid ester (NT200 made by Toyo Synthesis Industries, Ltd.) was added to the solution in an amount of 20% by mass relative to polyimide solid content, thereby preparing a positive type photosensitive polyimide ink.

In an environment at a relative humidity of 75%, the obtained positive type photosensitive polyimide composition ink was used on a 400-mesh screen printing plate to form a photosensitive film on a 30 µm thick stainless foil at a squeegee rate of 10 mm/sec. After printing, however, the film became gradually white. This whitening film was prebaked on a hot plate at 90°C for 10 minutes, but was not restored to a transparent film

The polyimide ink remained jammed in the screen mesh with an increase in the viscosity of the polyimide ink on the screen plate; printing could not be continued any longer.

The present invention can provide a block copolymerization type polyimide that is never whitened in the air unlike prior art solvent-soluble polyimides, and a positive type block copolymerization polyimide prepared using the inventive polyimide in combination with a photooxygenation agent, and an ink prepared from it enables relief other images to be formed with improved resolution.

## Claims

1. A block copolymerization polyimide composition, wherein a block copolymerization type polyimide having incorporated in its main chain phenolic hydroxy groups and being obtained from a tetracarboxylic dianhydride and a diamine is dissolved in at least one solvent selected from a ketone, an ether and an ester.

2. The block copolymerization polyimide composition according to claim 1, wherein the block copolymerization polyimide is obtained by heating a tetracarboxylic dianhydride and a diamine in at least one solvent selected from a ketone, an ether and an ester and in the presence of a catalyst resulting from a lactone and a base.

3. The block copolymerization polyimide composition according to claim 1 or 2, wherein the tetracarboxylic dianhydride is at least one selected from the group consisting of 3,3',4,4'-biphenyltetracarboxylic dianhydride, 3,3',4,4'-benzophenonetetracarboxycylic dianhydride, 3,3',4,4'-biphenyl ether tetracarboxylic dianhydride, 3,3',4,4'-diphenylsulfonetetracarboxylic dianhydride (DSDA), bicyclo(2,2,2)-oct-7-ene-2,3,5,6-tetracarboxylic.dianhydride, 1,2,4,5-cyclohexanetetracarboxylic dianhydride, 2,2-bis(3,4-dicarboxyphenyl)hexafluoropropane dianhydride, pyromellitic dianhydride, and 5-(2,5-dioxotetrahydrofuryl)-3-methyl-3-cyclohexene-1,2-dicarboxylic anhydride.

4. The block copolymerization polyimide composition according to claim 1 or 2, wherein the diamine is at least one selected from the group consisting of siliconediamine, bis(3-aminopropyl) ether ethane, 3,3'-diamino-4,4'-dihydroxydiphenylsulfone, 4,4'-diamino-3,3'-dihydroxybiphenyl, 2,2-bis (3-amino-4-hydroxyphenyl) hexafluoropropane, siloxanediamine, N,N-bis (3-aminopropyl)ether, 1,4-bis(3-aminopropyl)piperazine, isophoronediamine, 1,3'-bis(aminomethyl)cyclohexane, 3,3'-dimethyl-4,4'-diamino-dicyclohexylmethane, 4, 4'-methylenebis (cyclohexylamine), 4,4'-diaminodiphenyl ether, 3,4'-diaminodiphenyl ether, 3,3-diaminodiphenyl ether, 4,4'-diamino-diphenylsulfone, 3,4'-diamino-diphenylsulfone, 3,3'-diamino-diphenylsulfone, 2,4'-diaminodiphenyl ether, 1,3-bis(4-aminophenoxy)benzene (m-TPE), 1,3-bis(3-aminophenoxy)benzene, 2,2-bis[4-(4-aminophenoxy)phenyl]propane, 2,2-bis[4-(4-aminophenoxy) phenyl]hexafluoropropane, bis[4-(4-aminophenoxy)phenyl] sulfone, bis[4-(3-aminophenoxy)phenyl]sulfone, 4,4'-bis(4-aminophenoxy)biphenyl, 1,4-bis(4-aminophenoxy) benzene, 4,4'-diaminodiphenylsulfide, 3,4'-diaminodiphenylsulfide, 3,3'-diaminodiphenylsulfide, 3,3'-diamino-4,4'-dihydroxydiphenylsulfone, 2,4-diaminotoluene, 2,5-diaminotoluene, 2,6-diaminopyridine, 4,4'-diamino-3,3'-dimethoxy-biphenyl, 4,4'-diamino-3,3'-dimethylbiphenyl, and 9, 9' -bis(4-aminophenyl)fluorene.

5. The block copolymerization polyimide composition according to claim 1 or 2, wherein the diamine is at least one selected from the group consisting of 3,3'-diamine-4,4'-dihydroxydiphenylsulfone, 4,4'-diamino-3,3'-dihydroxybiphenyl, 2,2-bis[4-(4-aminophenoxy)phenyl]hexafluoropropane.

6. The block copolymerization polyimide composition according to claim 1 or 2, wherein the ketone is at least one selected from the group consisting of methyl ethyl ketone, methyl propyl ketone, methyl isopropyl ketone, methyl butyl ketone, methyl isobutyl ketone, methyl n-hexyl ketone, diethyl ketone, diisopropyl ketone, diisobutyl ketone, cyclopentanone, cylcohexanone, methylcyclohexanone acetylacetone, diacetone alcohol, and cyclohexen-1-one.

7. The block copolymerization polyimide composition according to claim 1, wherein the ether is at least one selected from the group consisting of dipropyl ether, diisopropyl ether, dibutyl ether, tetrahydrofuran, tetrahydropyran, ethyl isoamyl ether, ethyl-t-butyl ether, ethyl benzyl ether, cresyl methyl ether, anisole, and phenetole.

8. The block copolymerization polyimide composition according to claim 1 or 2, wherein the ester is at least one selected from the group consisting of methyl acetate, ethyl acetate, propyl acetate, isopropyl acetate, butyl acetate, isobutyl acetate, amyl acetate, isoamyl acetate, 2-ethylhexyl acetate, cyclohexyl acetate, methylcyclohexyl acetate, benzyl acetate, methyl acetoacetate, ethyl acetoacetate, methyl propionate, ethyl propionate, butyl propionate, benzyl propionate, methyl butyrate, ethyl butyrate, isopropyl butyrate, butyl butyrate, isoamyl butyrate, methyl lactate, ethyl lactate, butyl lactate, ethyl isovalerate, isoamyl isovalerate, diethyl oxalate, dibutyl oxalate, methyl benzoate, ethyl benzoate, propyl benzoate, and methyl salicylate.

9. The block copolymerization polyimide composition according to claim 1 or 2, wherein the solvent containing a ketone, an ether or an ester contains at least one selected from the group consisting of N-methylpyrrolidone, N,N-dimethylformamide, N,N-dimethylacetamide, and dimethylsulfoxide.

10. The block copolymerization polyimide composition according to claim 2, wherein the lactone is gamma - valerolactone, and the base is at least one of pyridine and N-methylmorpholine.

11. The block copolymerization polyimide composition according to claim 1 or 2, wherein the block copolymerization polyimide has a weight-average molecular weight of 10,000 to 200,000 as calculated on a polystyrene basis

12. A positive type photosensitive polyimide composition, which comprises the block copolymerization polyimide as defined in any of claims 1 to 5 and soluble in at least one solvent of an ether, a ketone and an ester, and a photooxygenation compound.

13. A positive type photosensitive block copolymerization polyimide ink composition, which comprises the block copolymerization polyimide as defined in any of claims 1 to 5 and soluble in at least one solvent of an ether, a ketone and an ester and a filler that is insoluble in a solvent.

14. A process of producing a block copolymerization polyimide composition having incorporated in its main chain phenolic hydroxyl groups, comprising steps of heating a tetracarboxylic dianhydride and a diamine in a solvent that contains at least one of a ketone, an ether or an ester and in the presence of an acid catalyst generated from a lactone and a base to form a polyimide oligomer, and adding either one of a tetracarboxylic dianhydride or a diamine to said polyimide oligomer for reaction therewith

15. A process of producing a block copolymerization polyimide composition having incorporated in its main chain phenolic hydroxyl groups, comprising steps of heating a tetracarboxylic dianhydride and a diamine in a solvent selected from the group consisting of N-methylpyrrolidone, N,N-dimethylformamide, N,N-dimethylacetamide and N,N-dimethylsulfoxide and in the presence of an acid catalyst generated from a lactone and a base to form a polyimide oligomer, then adding either one of a tetracarboxylic dianhydride or a diamine to said polyimide oligomer for reaction therewith, then subjecting a reaction product to precipitation using a poor solvent, filtration.and drying and finally dissolving a resulting product in a solvent comprising at least one of a ketone, an ether and an ester.

16. The process of producing a block copolymerization polyimide composition according to claim 14, wherein the lactone is gamma-valerolactone, and the base is at least one of pyridine and N-methylmorpholine.

## Patentansprüche

1. Polyimid-Blockcopolymerisations-Zusammensetzung, wobei ein Polyimid vom Blockcopolymerisationstyp mit in seiner Hauptkette eingebauten phenolischen Hydroxylgruppen und erhalten aus einem Tetracarboxyldianhydrid und einem Diamin, in mindestens einem Lösungsmittel, ausgewählt aus einem Keton, einem Ether und einem Ester, gelöst ist.

2. Polyimid-Blockcopolymerisations-Zusammensetzung nach Anspruch 1, wobei das Blockcopolymerisationspolyimid erhalten wird durch Erwärmen eines Tetracarboxyldianhydrids und eines Diamins in mindestens einem Lösungsmittel, ausgewählt aus einem Keton, einem Ether und einem Ester, und in Gegenwart eines Katalysators, der aus einem Lacton und einer Base resultiert.

3. Polyimid-Blockcopolymerisations-Zusammensetzung nach Anspruch 1 oder 2, wobei das Tetracarboxyldianhydrid mindestens eines, ausgewählt aus 3,3',4,4'-Biphenyltetracarboxyldianhydrid, 3,3',4,4'-Benzophenontetracarboxyldianhydrid, 3,3',4,4'-Biphenylethertetracarboxyldianhydrid, 3,3',4,4'-Diphenylsulfontetracarboxyldianhydrid (DSDA), Bicyclo(2,2,2)-oct-7-en-2,3,5,6-tetracarboxyldianhydrid, 1,2,4,5-Cyclohexantetracarboxyldianhydrid, 2,2-Bis(3,4-dicarboxyphenyl)hexafluorpropandianhydrid, Pyromellithdianhydrid und 5-(2,5-Dioxotetrahydrofuryl)-3-methyl-3-cyclohexen-1,2-dicarboyxlanhydrid, ist.

4. Polyimid-Blockcopolymerisations-Zusammensetzung nach Anspruch 1 oder 2, wobei das Diamin mindestens eines, ausgewählt aus Silikondiamin, Bis(3-aminopropyl)etherethan, 3,3'-Diamino-4,4'-dihydroxydiphenylsulfon, 4,4'-Diamino-3,3'-dihydroxybiphenyl, 2,2-Bis(3-amino-4-hydroxyphenyl)hexafluorpropan, Siloxandiamin, N,N-Bis(3-Aminopropyl)ether, 1,4-Bis(3-aminopropyl)piperazin, Isophorondiamin, 1,3'-Bis(aminomethyl)cyclohexan, 3,3'-Dimethyl-4,4'-diaminodicyclohexylmethan, 4,4'-Methylenbis(cyclohexylamin), 4,4'-Diaminodiphenylether, 3,4'-Diaminodiphenylether, 3,3-Diaminodiphenylether, 4,4'-Diaminodiphenylsulfon, 3,4'-Diaminodiphenylsulfon, 3,3'-Diaminodiphenylsulfon, 2,4'-Diaminodiphenylether, 1,3-Bis(4-aminophenoxy)benzol (m-TPE), 1,3-Bis(3-aminophenoxy)benzol, 2,2-Bis[4-(4-aminophenoxy)phenyl]propan, 2,2-Bis[4-(4-aminophenoxy)phenyl]hexafluorpropan, Bis[4-(4-aminophenoxy)phenyl]sulfon, Bis[4-(3-aminophenoxy)phenyl]sulfon, 4,4'-Bis(4-aminophenoxy)biphenyl, 1,4-Bis(4-aminophenoxy)benzol, 4,4'-Diaminodiphenylsulfid, 3,4'-Diaminodiphenylsulfid, 3,3'-Diaminodiphenylsulfid, 3,3'-Diamino-4,4'-dihydroxydiphenylsulfon, 2,4-Diaminotoluol, 2,5-Diaminotoluol, 2,6-Diaminopyridin, 4,4'-Diamino-3,3'-dimethoxybiphenyl, 4,4'-Diamino-3,3'-dimethylbiphenyl und 9,9'-Bis(4-aminophenyl)fluoren, ist.

5. Polyimid-Blockcopolymerisations-Zusammensetzung nach Anspruch 1 oder 2, wobei das Diamin mindestens eines, ausgewählt aus 3,3'-Diamino-4,4'-dihydroxydiphenylsulfon, 4,4'-Diamino-3,3'-dihydroxybiphenyl, 2,2-bis[4-(4-Aminophenoxy)phenyl]hexafluorpropan, ist.

6. Polyimid-Blockcopolymerisations-Zusammensetzung nach Anspruch 1 oder 2, wobei das Keton mindestens eines, ausgewählt aus Methylethylketon, Methylpropylketon, Methylisopropylketon, Methylbutylketon, Methylisobutylketon, Methyl-n-hexylketon, Diethylketon, Diisopropylketon, Diisobutylketon, Cyclopentanon, Cyclohexanon, Methylcyclohexanon, Acetylaceton, Diacetonalkohol und Cyclohexen-1-on, ist.

7. Polyimid-Blockcopolymerisations-Zusammensetzung nach Anspruch 1, wobei der Ether mindestens einer, ausgewählt aus Dipropylether, Diisopropylether, Dibutylether, Tetrahydrofuran, Tetrahydropyran, Ethylisoamylether, Ethyl-t-butylether, Ethylbenzylether, Cresylmethylether, Anisol und Phenethol, ist.

8. Polyimid-Blockcopolymerisations-Zusammensetzung nach Anspruch 1 oder 2, wobei der Ester mindestens einer, ausgewählt aus Methylacetat, Ethylacetat, Propylacetat, Isopropylacetat, Butylacetat, Isobutylacetat, Amylacetat, Isoamylacetat, 2-Ethylhexylacetat, Cyclohexylacetat, Methylcyclohexylacetat, Benzylacetat, Methylacetoacetat, Ethylacetoacetat, Methylpropionat, Ethylpropionat, Butylpropionat, Benzylpropionat, Methylbutyrat, Ethylbutyrat, Isopropylbutyrat, Butylbutyrat, Isoamylbutyrat, Methyllactat, Ethyllactat, Butyllactat, Ethylisovalerat, Isoamylisovalerat, Diethyloxalat, Dibutyloxalat, Methylbenzoat, Ethylbenzoat, Propylbenzoat und Methylsalicylat, ist.

9. Polyimid-Blockcopolymerisations-Zusammensetzung nach Anspruch 1 oder 2, wobei das ein Keton, einen Ether oder einen Ester enthaltende Lösungsmittel mindestens eines, ausgewählt aus N-Methylpyrrolidon, N,N-Dimethylformamid, N,N-Dimethylacetamid und Dimethylsulfoxid, enthält.

10. Polyimid-Blockcopolymerisations-Zusammensetzung nach Anspruch 2, wobei das Lacton gamma-Valerolacton ist und die Base mindestens eine aus Pyridin und N-Methylmorpholin ist.

11. Polyimid-Blockcopolymerisations-Zusammensetzung nach Anspruch 1 oder 2, wobei das Blockcopolymerisationspolyimid ein Gewichtsmittel des Molekulargewichts von 10 000 bis 200 000 aufweist, wie auf einer Polystyrolbasis errechnet.

12. Photoempfindliche Polyimidzusammensetzung vom positiven Typ, welche das Blockcopolymerisationspolyimid wie in einem der Ansprüche 1 bis 5 definiert und löslich in mindestens einem Lösungsmittel eines Ethers, eines Ketons und eines Esters, und eine Photooxygenierungs-Verbindung umfasst.

13. Photoempfindliche Polyimid-Blockcopolymerisations-Tintenzusammensetzung vom positiven Typ, welche das Blockcopolymerisationspolyimid wie in einem der Ansprüche 1 bis 5 definiert und löslich in mindestens einem Lösungsmittel eines Ethers, eines Ketons und eines Esters, und einen Füllstoff, der im Lösungsmittel unlöslich ist, umfasst.

14. Verfahren zur Herstellung einer Polyimid-Blockcopolymerisations-Zusammensetzung mit in ihrer Hauptkette eingebauten phenolischen Hydroxylgruppen, umfassend Schritte des Erwärmens eines Tetracarboxyldianhydrids und eines Diamins in einem Lösungsmittel, das mindestens eines von einem Keton, einem Ether oder einem Ester enthält, und in Gegenwart eines Säurekatalysators, erzeugt aus einem Lacton und einer Base, um ein Polyimidoligomer zu bilden, und Hinzufügen entweder eines Tetracarboxyldianhydrids oder eines Diamins zu dem Polyimidoligomer zur Reaktion damit.

15. Verfahren zur Herstellung einer Polyimid-Blockcopolymerisations-Zusammensetzung mit in ihrer Hauptkette eingebauten phenolischen Hydroxylgruppen, umfassend Schritte des Erwärmens eines Tetracarboxyldianhydrids und eines Diamins in einem Lösungsmittel, ausgewählt aus N-Methylpyrrolidon, N,N-Dimethylformamid, N,N-Dimethylacetamid und N,N-Dimethylsulfoxid, und in Gegenwart eines Säurekatalysators, erzeugt aus einem Lacton und einer Base, um ein Polyimidoligomer zu bilden und dann Hinzufügen entweder eines Tetracarboxyldianhydrids oder eines Diamins zu dem Polyimidoligomer zur Reaktion damit, dann Unterziehen eines Reaktionsprodukts einer Ausfällung unter Verwendung eines schwachen Lösungsmittels, Filtern und Trocknen und schließlich Lösen eines resultierenden Produkts in einem Lösungsmittel, das mindestens eines von einem Keton, einem Ether und einem Ester umfasst.

16. Verfahren zur Herstellung einer Polyimid-Blockcopolymerisations-Zusammensetzung nach Anspruch 14, wobei das Lacton gamma-Valerolacton ist und die Base mindestens eine von Pyridin und N-Methylmorpholin ist.

## Revendications

1. Composition de polyimide de copolymérisation séquencée où un polyimide, de type copolymérisation séquencée ayant des groupes hydroxyle phénolique incorporés dans sa chaîne principale et étant obtenu à partir d'un dianhydride tétracarboxylique et d'une diamine dissous dans au moins un solvant choisi parmi une cétone, un éther et un ester.

2. Composition de polyimide de copolymérisation séquencée selon la revendication 1 où le polyimide de copolymérisation séquencée est obtenu par chauffage d'un dianhydride tétracarboxylique et d'une diamine dans au moins un solvant choisi parmi une cétone, un éther et un ester et en présence d'un catalyseur résultant d'une lactone et d'une base.

3. Composition de polyimide de copolymérisation séquencée selon la revendication 1 ou 2 où le dianhydride tétracarboxylique est au moins un choisi dans le groupe consistant en le dianhydride 3,3',4,4'-biphényltétracarboxylique, le dianhydride 3,3',4,4'-benzophénonetétracarboxylique, le dianhydride 3,3',4,4'-biphényléthertétracarboxylique, le dianhydride 3,3',4,4'-diphénylsulfonetétracarboxylique (DSDA), le dianhydride bicyclo(2,2,2)-oct-7-ène-2,3,5,6-tétracarboxylique, le dianhydride 1,2,4,5-cyclohexanetétracarboxylique, le dianhydride de 2,2-bis(3,4-dicarboxyphényl)hexafluoropropane, le dianhydride pyromellitique et le anhydride 5-(2,5-dioxotétrahydrofuryl)-3-méthyl-3-cyclohexène-1,2-dicarboxylique.

4. Composition de polyimide de copolymérisation séquencée selon la revendication 1 ou 2 où la diamine est au moins une choisie dans le groupe consistant en la siliconediamine, le bis(3-aminopropyl)éther éthane, la 3,3'-diamino-4,4'-dihydroxydiphénylsulfone, le 4,4'-diamino-3,3'-dihydroxybiphényle, le 2,2-bis(3-amino-4-hydroxyphényl)hexafluoropropane, la siloxanediamine, le N,N-bi-(3-aminopropyl)éther, la 1,4-bis(3-aminopropyl)pipérazine, l'isophoronediamine, le 1,3'-bis(aminométhyl)cyclohexane, le 3,3'-diméthyl-4,4'-diaminodicyclohexylméthane, la 4,4'-méthylénebis(cyclohexylamine), le 4,4'-diaminodiphényléther, le 3,4'-diaminodiphényléther, le 3,3-diaminodiphényléther, la 4,4'-diamino-diphénylsulfone, la 3,4'-diamino-diphénylsulfone, la 3,3'-diamino-diphénylsulfone, le 2,4'-diaminodiphénylether, le 1,3-bis(4-aminopbénoxy)benzène (m-TPE), le 1,3-bis(3-aminophénoxy)benzéne, le 2,2-bis[4-(4-aminophénoxy)phényl]propane, le 2,2-bis[4-(4-aminophénoxy)phényl]hexanfluoropropane, la bis[4-(4-aminophénoxy)phényl]sulfone, la bis[4-(3-aminophénoxy)phényl]sulfone, le 4,4'-bis(4-aminophénoxy)biphényle, le 1,4-bis(4-aminophénoxy)benzène, le 4,4'-diaminodiphénylsulfure, le 3,4'-diaminodiphénylsulfure, le 3,3'-diaminodiphénylsulfure, la 3,3'-diamino-4,4'-dihydroxydiphénylsulfone, le 2,4-diaminotoluéne, le 2,5-diaminotoluène, la 2,6-diaminopyridine, le 4,4'-diamino-3,3'-diméthoxy-biphényle, le 4,4'-diamino-3,3'-diméthylbiphényle et le 9,9'-bis(4-aminophényl)fluorène.

5. Composition de polyimide de copolymérisation séquencée selon la revendication 1 ou 2 où la diamine est au moins une choisie dans le groupe consistant en la 3,3'-diamino-4,4'-dihydroxydiphénylsulfone, le 4,4'-diamino-3,3'-dihydroxybiphényle, le 2,2-bis[4-(4-aminophénoxy)phényl]hexafluoropropane.

6. Composition de polyimide de copolymérisation séquencée selon la revendication 1 ou 2 où la cétone est au moins une choisie dans le groupe consistant en la méthyl éthyl cétone, la méthyl propyl cétone, la méthyl isopropyl cétone méthyl butyl cétone, la méthyl isobutyl cétone, la méthyl n-hexyl cétone, la diéthyl cétone, la diisopropyl cétone, la diisobutyl cétone, la cyclopentanone, la cyclohexanone, la méthylcyclohexanone, l'acétylacétone, le diacétone alcool et la cyclohexén-1-one,

7. Composition de polyimides de copolymérisation séquencée selon la revendication 1 où l'éther est au moins un choisi dans le groupe consistant en le dipropyl éther, le diisopropyl éther, le dibutyl éther, le tétrahydrofurane, le tétrahydropyrane, l'éthyl isoamyl éther, l'éthyl-t-butyl éther, l'éthyl benzyl éther, le crésyl méthyl éther, l'anisole et le phénétole.

8. Composition de polyimide de copolymérisation séquencée selon la revendication 1 ou 2 où l'ester est au moins un choisi dans le groupe consistant en l'acétate de méthyle, l'acétate d'éthyle, l'acétate de propyle, l'acétate d'isopropyle, l'acétate de butyle, l'acétate d'isobutyle, l'acétate d'amyle, l'acétate d'isoamyle, l'acétate de 2-éthylhexyle, l'acétate de cyclohexyle, l'acétate de méthylcyclohexyle, l'acétate de benzyle, l'acétoacétate de méthyle, l'acétoacétate d'éthyle, le propionate de méthyle, le propionate d'éthyle, le propionate de butyle, le propionate de benzyle, le butyrate de méthyle, le butyrate d'éthyle, le butyrate d'isopropyle, le butyrate de butyle, le butyrate d'isoamyle, le lactate de méthyle, le lactate d'éthyle, le lactate de butyle, l'isovalérate d'éthyle, l'isovalérate d'isoamyle, l'oxalate de diéthyle, l'oxalate de dibutyle, le benzoate de méthyle, le benzoate d'éthyle, le benzoate de propyle et le salicylate de méthyle.

9. Composition de polyimide de copolymérisation séquencée selon la revendication 1 ou 2 où le solvant contenant une cétone, un éther ou un ester contient au moins un choisi dans le groupe consistant en la N-méthylpyrrolidone, le N,N-diméthylformamide, le N,N-diméthylacétamide et le diméthylsulfoxyde.

10. Composition de polyimide de copolymérisation séquencée selon la revendication 2 où la lactone est la gamma-valérolactone et la base est au moins une parmi la pyridine et la N-méthylmorpholine.

11. Composition de polyimide de copolymérisation séquencée selon la revendication 1 ou 2 où le polyimide de copolymérisation séquencée a une masse moléculaire moyenne en poids de 10000 à 200000 calculée sur une base de polystyrène.

12. Composition de polyimide photosensible de type positif qui comprend le polyimide de copolymérisation séquencée selon l'une quelconque des revendications 1 à 5 et soluble dans au moins un solvant parmi un éther, une cétone et un ester, et un composé de photooxygénation.

13. Composition d'encre de polyimide de copolymérisation séquencée photosensible de type positif qui comprend le polyimide de copolymérisation séquencée selon l'une quelconque des revendications 1 à 5 et soluble dans au moins un solvant parmi un éther, une cétone et un ester, et une charge qui est insoluble dans un solvant.

14. Procédé de production d'une composition de polyimide, de copolymérisation séquencée ayant des groupes hydroxyle phénoliques incorporés dans sa chaîne principale, comprenant les étapes de chauffage d'un dianhydride tétracarboxylique et d'une diamine dans un solvant qui contient au moins l'un parmi une cétone, un éther et un ester et en présence d'un catalyseur acide produit à partir d'une lactone et d'une base pour former un oligomère de polyimide, et d'addition de l'un quelconque parmi un dianhydrides tétracarboxylique et une diamine audit oligomère de polyimide pour réagir avec lui.

15. Procédé de production d'une composition de polyimide de copolymérisation séquencée ayant des groupes hydroxyle phénoliques incorporés dans sa chaîne principale, comprenant les étapes de chauffage d'un dianhydride tétracarboxylique et d'une diamine dans un solvant choisi dans le groupe consistant en la N-méthylpyrrolidone, le N,N-diméthylformamide, le N,N-diméthylacétamide et le N,N-diméthylsulfoxyde et en présence d'un catalyseur acide produit à partir d'une lactone et d'une base pour former un oligomère de polyimide, puis d'addition de l'un quelconque parmi un dianhydrides tétracarboxylique et une diamine audit oligomère de polyimide pour réagir avec lui, puis d'exposition d'un produit réactionnel à une précipitation au moyen d'un solvant médiocre, de filtration et de séchage, et finalement de dissolution d'un produit résultant dans un solvant comprenant au moins l'un parmi une cétone, un éther et un ester.

16. Procédé de production d'une composition de polyimide de copolymérisation séquencée selon la revendication 14 où la lactone est la gamma-valérolactone, et la base est au moins l'une parmi la pyridine, et la N-méthylmorpholine.
